# EUROPEAN PATENT APPLICATION

(11) **EP 4 716 387 A1**
(43) Date of publication of application: **25.03.2026**
(21) Application number: 25204401.1
(22) Date of filing: 24.09.2025
(51) Int. Cl.: H05K 7/14, H05K 7/20

(54) **ROLL FORMED LIQUID COOLED BUSBAR**

(30) Priority: 24.09.2024 US 202463698247 P; 02.09.2025 US 202519316775
(71) Applicant: Vertiv Corporation, Westerville, OH 43082 (US)
(72) Inventor: WILSON, Brad L., Westerville, 43082 (US)
(74) Representative: Kilburn & Strode LLP

(57) **Abstract**

A liquid-cooled roll-formed busbar assembly comprises a sheet of copper or similarly conductive metal roll-formed into at least one arcuate region. One or more cooling pipes of a fluid network (e.g., a coolant supply pipe and a coolant return pipe) circulate a cooling fluid through the busbar such that the arcuate region/s conform to a portion of the external circumference of the cooling pipe/s. A thermal interface is disposed between the cooling pipes and the liquid-cooled roll-formed busbar, such that the circulating fluid absorbs heat from the busbar via the thermal interface and transfers the absorbed heat to a primary fluid network.

## Description

### CROSS-REFERENCE TO RELATED APPLICATIONS

The present application claims the benefit under 35 U.S.C. § 119(e) of U.S. Provisional Patent Application Serial Number 63/698,247 filed September 24, 2024, titled ROLL FORMED LIQUID COOLED OPEN COMPUTE PROJECT (OCP) COMPATIBLE BUSBAR.

### TECHNICAL FIELD

The present disclosure is directed generally to the field of power distribution, and more particularly to devices and components for power distribution in information technology (IT) environments.

### BACKGROUND

The Open Compute Project (OCP) defines a nominal 48 V busbar mountable in the rear of a server rack or server cabinet otherwise compliant with OCP standards. This nominal OCP busbar provides for blind mate connections both to power sources and to IT equipment (e.g., servers, switches) disposed within the rack or cabinet, carrying operating power to the IT equipment via the busbar and blind mate connections. However, current increases in power density and the likely demands of next-generation artificial intelligence and/or machine learning (AI/ML) applications have led, in the present, to redesigning the busbar to add copper in order to provide additional current carrying capacity. Further, given the demands of future AI/ML applications, the busbar can also be expected to carry higher ampacity levels, which translates to additional generated heat. The expected increase in heat may be a primary limiting influence on further load increases. Further, the increase in generated heat is exacerbated by a layout that provides operating power from the top and bottom of the busbar, maintaining the middle of the rack or cabinet for placement of IT devices and allowing closer coupling of AI/ML associated servers. The heat increase is of higher priority with respect to those devices adjacent to power source shelves near the top or bottom of the rack or server.

### SUMMARY

In a first aspect, a liquid cooled roll formed busbar assembly for a server rack, server cabinet, or any appropriate configuration of servers and/or other information technology (IT) devices is disclosed. In examples, the busbar assembly may include a roll-formed busbar comprising a sheet of highly conductive metal configured for carrying a current load between a power source and the servers/IT devices, either directly or via power distribution units (PDU) and/or shelf-level or rack-level busbars. In examples, the busbar may be roll-formed into one or more arcuate regions. The arcuate regions may conform to the external circumferences of cooling pipes defining a portion of a secondary fluid network (SFN). In examples, the cooling pipes may circulate a cooling fluid and are similarly a highly thermally conductive material, and the arcuate regions of the busbar may contact the cooling pipes via thermal interfaces such that heat is transferred from the busbar to the cooling fluid via the thermal interfaces and conductive exterior of the cooling pipes.

In some examples, the busbar may be partially or fully formed of copper.

In some examples, the cooling pipes may be partially or fully formed of copper.

In some examples, the thermal interface may include carbon nanotubes.

In some examples, the roll-formed busbar may physically and thermally contact 30 percent or more (108 degrees or more) of the outer circumference of the cooling pipes.

In some examples, the thermal interface may physically and thermally contact 30 percent or more (108 degrees or more) of the outer circumference of the cooling pipes.

In some examples, the thermal interface and cooling pipes may be formed of an electrically conductive material, and the cooling pipes may carry an additional current load between the power source and the servers/IT devices (e.g., via PDUs and/or shelf level busbars).

In some examples, the current-carrying cooling pipes may be connected to the secondary fluid network via non-conductive pipe fittings.

In some examples, the cooling fluid circulated by the cooling pipes may be an electrically non-conductive fluid.

In a further aspect, a method for providing operating power to one or more information technology (IT) devices is disclosed. In examples, the method may include providing one or more servers, switches, or other IT devices disposed within a server rack. The method may include providing a power source (e.g., DC, AC, in or on the rack or external thereto) for supplying operating current to the IT devices. The method may include providing a fluid network for thermal management of the IT devices, the fluid network including cooling pipes for circulating a fluid refrigerant through the rack and/or IT devices to absorb heat generated therein and remove the heat from the environment. The method may include providing a roll formed busbar attached to the rack for carrying the current load between the power source and the IT devices; for example, the busbar may be a metallic sheet roll formed into one or more arcuate regions conforming to an outer circumference of the cooling pipes. The method may include providing a thermal interface fashioned of thermally conductive materials between the arcuate regions and the cooling pipes.

In some examples, the method may include providing a busbar partially or fully fashioned of copper.

In some examples, the method may include providing one or more cooling pipes partially or fully fashioned of copper.

In some examples, the method may include providing a busbar configured for physical and thermal contact with not less than 30 percent (e.g., 108 degrees) of the outer circumference of the cooling pipes.

In some examples, the method may include providing a thermal interface configured for physical and thermal contact with not less than 30 percent (e.g., 108 degrees) of the outer circumference of the cooling pipes.

In some examples, the method may include providing a thermal interface wherein the thermally conductive materials include carbon nanotubes.

In some examples, the method may include, when the thermally conductive material includes electrically conductive material, connecting a portion of the cooling pipes to the remainder of the fluid network via electrically non-conductive fittings.

In some examples, the method may include circulating an electrically non-conductive fluid refrigerant through the fluid network.

In some examples, the method may include providing an additional current load between the power source and one or more IT devices via the cooling pipes.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various examples of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a diagrammatic illustration of a prior art busbar;
FIG. 2 is an overhead view of prior art busbars;
FIG. 3A is a profile view of a liquid-cooled roll-formed busbar assembly according to examples of the present disclosure;
FIG. 3B is an overhead view of the liquid-cooled roll-formed busbar assembly of FIG. 3A;
FIG. 4 is a diagrammatic illustration of the liquid-cooled roll-formed busbar assembly of FIGS. 3A and 3B in an information technology (IT) environment;
and FIG. 5 is a process flow diagram illustrating a method for providing operating power to IT devices according to examples of the present disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "some examples" means that a particular element, feature, structure, or characteristic described in connection with the example is included in at least one example disclosed herein. The appearances of the phrase "in some examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Broadly speaking, examples of the present disclosure are directed to a liquid-cooled busbar assembly. For example, the liquid-cooled busbar may include copper or another like conductive metal roll-formed to conform tightly to a pipe or conduit capable of circulating a cooling fluid and thus cooling the busbar. Liquid cooling may enable the busbar to carry a larger current load without a corresponding increase in material. As commercial copper is associated with a volatile price index, limiting the copper content of the busbar helps control costs and reduce cost variation. Further, when the cooling conduit is similarly a pipe of copper or a like conductive metal, the cooling pipe itself may provide additional current carrying capacity.

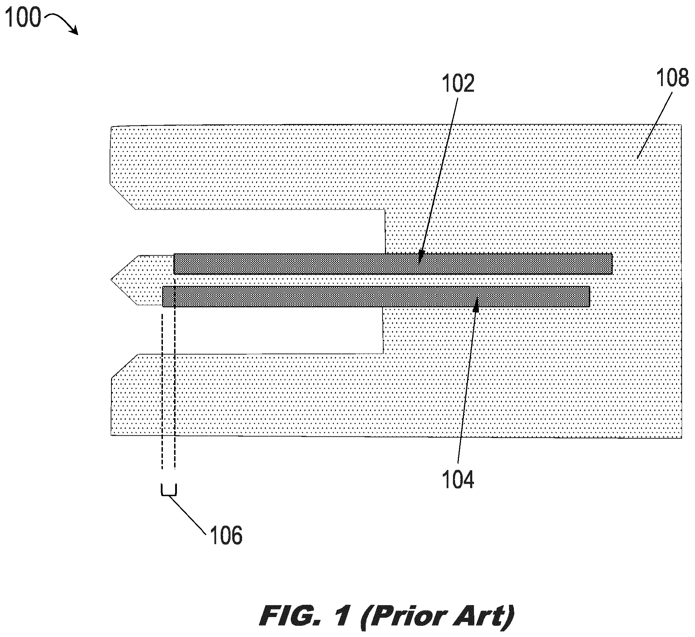

Referring to FIG. 1, a prior art legacy busbar assembly 100 is shown.

The legacy busbar assembly 100 may include a 48 V flat vertical rack-level busbar 102 (e.g., power distribution busbar (PDBB)) and a return busbar 104 offset (106) from the busbar 102. For example, the legacy busbar assembly 100 may be mounted to the rear or in a corner of a server rack or cabinet. The rack-level busbar 102 and/or return busbar 104 may be fashioned of copper and silver plated at interface points (e.g., where the rack-level legacy busbar interfaces with horizontal shelf-level busbars, as discussed in greater detail below). The rack-level busbar 102 and/or return busbar 104 may further include a protective busbar cover 108 covering a portion of the busbar not providing operating current to a shelf-level busbar or to an IT device directly.

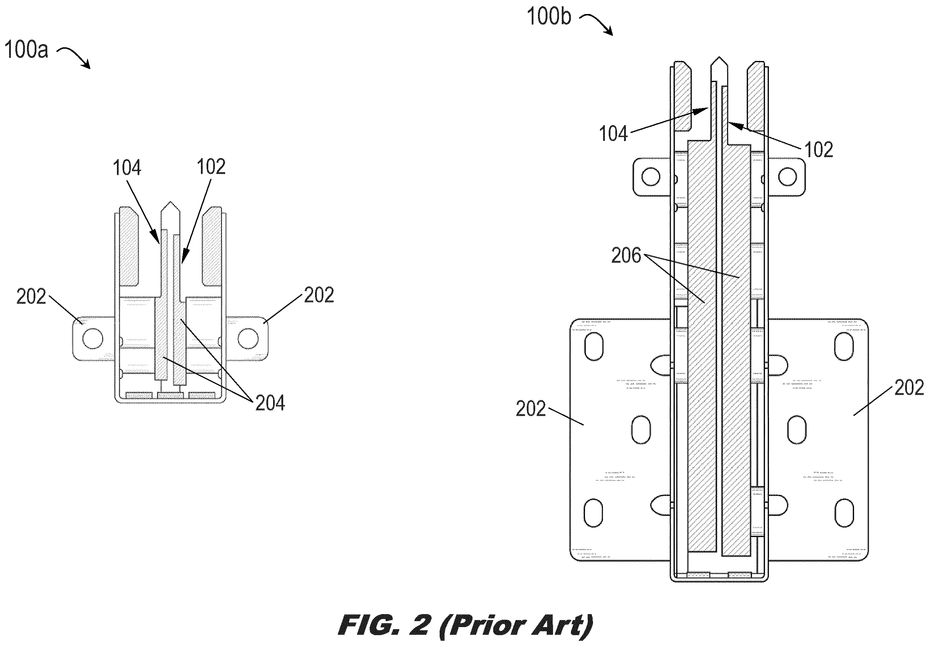

Referring also to FIG. 2, the prior art legacy busbar assemblies 100a, 100b may respectively incorporate Open Rack v. 3 (ORV3) and High Power (HPR) variants of the legacy busbar 102. Both legacy busbar assemblies 100a, 100b may include connectors 202 for mounting horizontal shelf-level busbars, IT trays, power shelves, servers, switches, and/or other IT devices. Further, the ORV3 legacy busbar assembly 100a may include steps 204, 206, or thicker sections of copper allowing greater current carrying capacity while preserving the size of the connectors 202. With respect to the ORV3/HPR legacy busbar assembly 100b, the steps 206 may likewise include extended lengths of copper busbar to accommodate significant load increases, e.g., associated with AI/ML applications. However, as can clearly be seen, the increase in load capacity is achieved only by a corresponding increase in the volume of copper used.

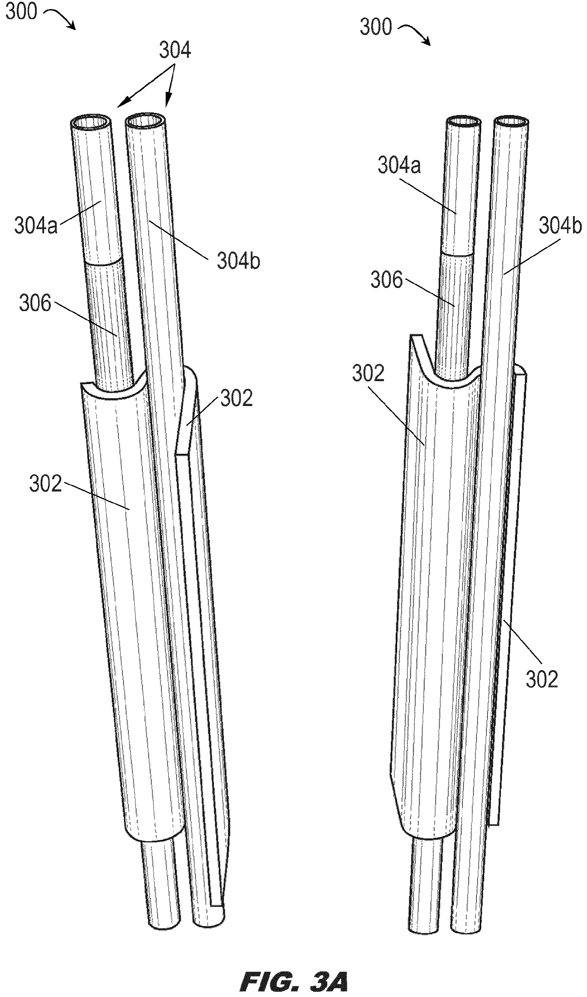

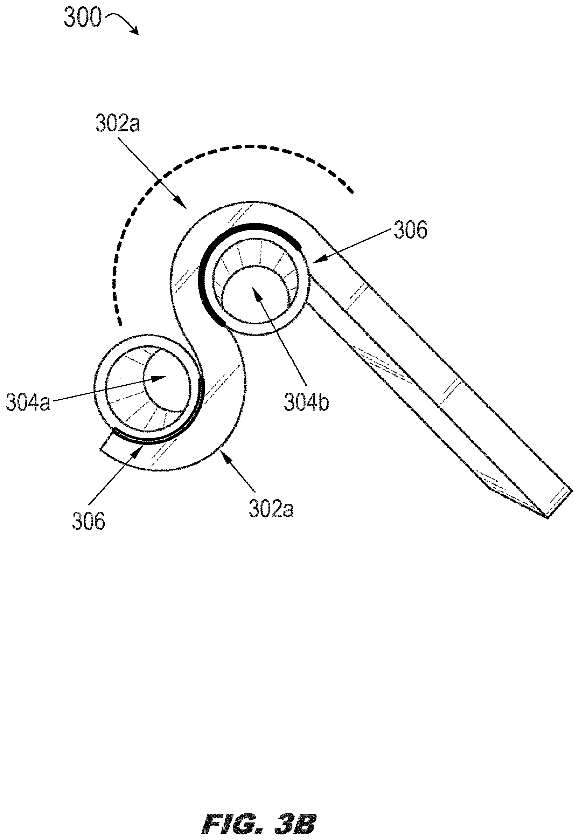

Referring generally to FIGS. 3A and 3B, a liquid cooled busbar assembly 300 is shown in lateral and overhead views respectively. The liquid cooled busbar assembly 300 may include a liquid-cooled roll-formed busbar 302, cooling pipes 304, and thermal interface 306.

In examples, the liquid-cooled roll-formed busbar 302 may include a sheet of copper (e.g., or other like metal having sufficient conductivity and malleability) roll formed such that an arcuate portion 302a of the busbar may tightly conform (e.g., electrically, mechanically, thermally) to an external circumference (e.g., outer circumference) of each cooling pipe 304. For example, examples of the liquid-cooled roll-formed busbar 302 may be roll formed through a bend of at least 108 degrees, such that at least 30 percent of the external circumference of each cooling pipe 304 may conform to and thermally/physically contact the busbar. In some examples, the roll-formed busbar 302 may conform to and contact 30 percent or more (e.g., 108 degrees) of the external circumference of each cooling pipe 304.

In some examples, the cooling pipes 304 may include a coolant supply pipe 304a and/or a coolant return pipe 304b. For example, the cooling pipes 304 may be connected to a secondary fluid network (SFN) as provided by a two-phase coolant delivery system, or any other fluid network via which a fluid refrigerant is circulated through the busbar assembly 300 (e.g., via coolant supply pipe 304a) to absorb heat from the liquid-cooled roll-formed busbar 302 and return the warmer fluid refrigerant (e.g., to a fluid refrigerant supply) for rechilling and recirculation. In some examples, the cooling pipes 304 and fluid network may pass through the busbar assembly 300 en route to an IT device and/or chip assembly thereof. Alternatively, the cooling pipes 304 and fluid network may be dedicated to thermal management of the busbar assembly 300 and may collect or absorb heat from the liquid-cooled roll-formed busbar 302 exclusively. In examples, similarly to the liquid-cooled roll-formed busbar 302, the cooling pipes 304 may be partially or fully fashioned of copper or a similarly thermally conductive material.

In some examples, the busbar assembly 300 may include a thermal interface 306 disposed between the liquid-cooled roll-formed busbar 302 and cooling pipes 304 (e.g., coolant supply pipe 304a). For example, the thermal interface 306 may include carbon nanotube fabric (e.g., Carbice^{®}) or other appropriate thermally conductive materials. In examples, where the cooling pipes 304 are partially or fully fashioned of copper (or similarly electrically conductive material), one or more cooling pipes may be configured to carry a current load in addition to (e.g., supplementary to) the current load carried by the liquid-cooled roll-formed busbar 302. For example, by configuring the cooling pipes 304 to carry a current load, the busbar assembly 300 may carry additional ampacity while reducing or eliminating the need to increase the size or copper content of the busbar accordingly (as with, e.g., the ORV3/HPR legacy busbar 100b shown by FIG. 2) and while maintaining adequate thermal management. In some examples, the thermal interface 306 may be configured for physical and thermal contact with at least 30 percent (e.g., 108 degrees) of the outer circumference of each cooling pipes 304. For example, the thermal interface 306 may physically and thermally interface between the liquid-cooled roll-formed busbar 302 and each cooling pipe 304a, 304b to an extent equivalent to the degree that the roll-formed busbar and the outer circumference of the cooling pipe would otherwise make direct thermal and physical contact. In some examples, the region of physical and thermal contact between the liquid-cooled roll formed busbar and each cooling pipe, as well as the region of physical and thermal contact between the thermal interface and each cooling pipe, may not be consistent between cooling pipes 304a, 304b.

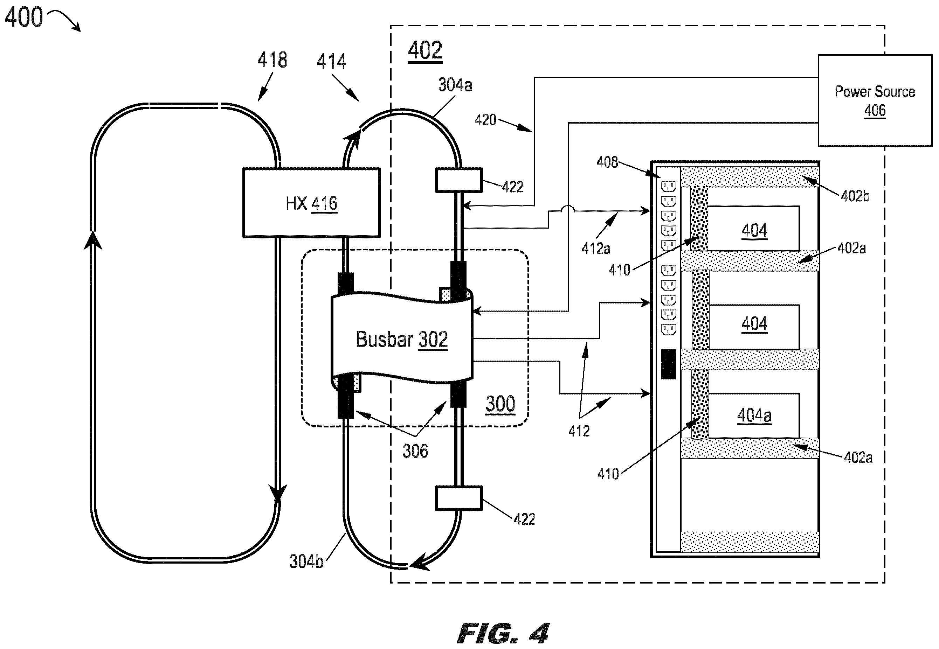

Referring now to FIG. 4, an information technology (IT) environment 400 is shown.

In examples, the busbar assembly 300 as shown by FIG. 3 may be implemented in a server rack 402 or server cabinet within the IT environment 400. For example, the server rack 402 may house various IT devices 404 (e.g., servers, switches), e.g., on its shelves 402a. Further, the busbar assembly 300, including the liquid-cooled roll-formed busbar 302, may be mounted within the server rack 402 and may interface with, e.g., a power source 406 (e.g., one or more batteries or other appropriate direct current (DC) sources housed on a power shelf 402b near the top of the server rack, or an alternating current (AC) power source powering the busbar) and power distribution units 408 (PDU; e.g., rack PDUs connected to individual IT devices 404 or to shelf-level busbars 410) and/or shelf-level horizontal busbars, e.g., disposed on or near lower shelves 402a of the server rack, which lower shelves may also support the IT devices. For example, the liquid-cooled roll-formed busbar 302 may carry operating current 412 from the power source 406 to PDUs 408 or shelf-level busbars 410, which PDUs or shelf-level busbars may in turn provide operating power to proximate IT devices 404.

In examples, the coolant supply pipe 304a and coolant return pipe-304b, directly interfacing with the liquid-cooled roll-formed busbar 302 via thermal interface 306, may be connected to a secondary fluid network 414 (SFN). For example, the SFN 414 may circulate fluid refrigerant through the busbar assembly 300, absorbing heat from the liquid-cooled roll-formed busbar 302 via direct thermal contact and circulating the resulting warmer fluid refrigerant to heat exchangers 416 (HX) where the fluid refrigerant is rechilled and recirculated. Further, the heat exchangers 416 may transfer absorbed heat from the SFN 414 to a primary fluid network 418 (PFN) for removal from the environment 400. In some examples, the SFN 414 may circulate fluid refrigerant through the server rack 402 to absorb heat generated by the IT devices 404. In other examples, the SFN 414 may provide thermal management of the busbar assembly 300 exclusively.

In examples, and as noted above, the cooling pipes 304 may be fashioned of copper and at least one coolant supply pipe 304a may carry an additional current load 420 from the power source 406, such that some IT devices 404a may draw operating current 412a directly via the coolant supply pipe rather than via the liquid-cooled roll-formed busbar 302. For example, when the coolant supply pipe 304a is carrying an additional current load 420, the coolant supply pipe may be connected to the SFN 414 via non-conductive fittings 422 (e.g., SharkBite^{®} connectors) in order to insulate the SFN. Similarly, in examples the SFN 414 may circulate an electrically non-conductive fluid refrigerant, e.g., thermally conductive but not electrically conductive.

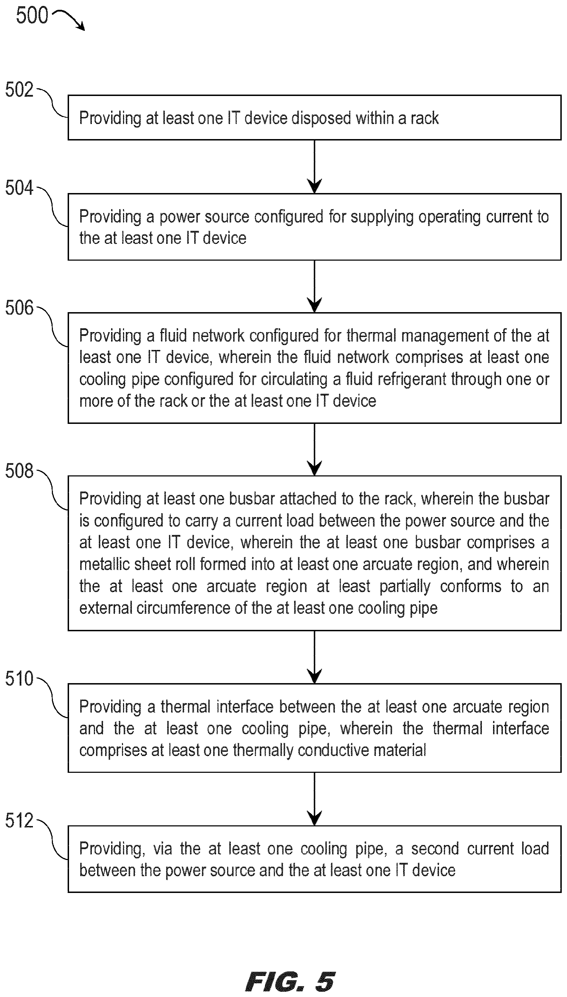

Referring now to FIG. 5, the method 500 may be implemented by and within the IT environment 400 and may include the following steps.

At a step 502, a server rack is provided with one or more information technology (IT) devices, e.g., servers, switches, disposed within the server rack, e.g., mounted to shelves thereof.

At a step 504, a power source is provided for supplying operating power, e.g., current load, to the IT devices.

At a step 506, a fluid network is provided for thermal management of the IT devices, e.g., for removal of thermal energy generated by the IT devices based on the supplied operating power. In some examples, the fluid network includes one or more cooling pipes for circulating a fluid refrigerant through the rack and/or IT devices to absorb and remove heat therefrom. For example, the cooling pipes may include a supply pipe wherein the fluid refrigerant is pumped from a supply (or, in the case of a secondary fluid network, pumped from a heat exchanger) to the rack and/or IT devices, and a return pipe whereby the fluid refrigerant, having absorbed heat from the rack and/or IT devices, is returned to the supply or heat exchanges for re-cooling (and, e.g., removal of absorbed heat from the IT environment). In some examples, the cooling pipes are partially or fully fashioned from copper. In some examples, the cooling pipes comprise a portion of the fluid network connected to the remainder of the fluid network via electrically non-conductive fittings. Further, the fluid refrigerant is an electrically non-conductive fluid.

At a step 508, a busbar is attached to the rack for carrying the current load between the power source and IT devices. In some examples, the busbar is roll formed from a metallic sheet into one or more arcuate regions, such that the arcuate regions conform to the outer circumference of the supply pipes. In some examples, the arcuate regions conform to at least 30 percent of the outer circumference (e.g., for the length of the busbar) of each supply pipe. In some examples, the busbar is partially or fully fashioned from copper.

At a step 510, a thermal interface is provided between the arcuate regions of the busbar and the cooling pipes, such that the arcuate regions and the cooling pipes are in thermal communication therethrough. For example, the thermal interface is fashioned of thermally conductive materials. In some examples, the thermally conductive materials include carbon nanotubes. In some examples, the thermally conductive materials are also electrically conductive.

In some examples, the method 500 includes an extra step 512. At the step 512, when the thermal interface between the arcuate busbar regions and the cooling pipes is electrically conductive as well as thermally conductive, when the fluid refrigerant is an electrically non-conductive fluid, and when the cooling pipes define a conductive portion of the fluid network connected to the rest of the fluid network via electrically non-conductive fittings, an additional current load is provided between the power source and one or more IT devices via the cooling pipes comprising the conductive portion of the fluid network.

The following clauses are described herein:
1. A busbar assembly, comprising:
   at least one busbar attached to a rack, the busbar configured to carry a current load between a power source and at least one information technology, IT, device disposed within the rack, the at least one busbar comprising a metallic sheet roll formed into at least one arcuate region;
   at least one cooling pipe defining a portion of a fluid network configured for circulating a fluid refrigerant through at least one of the rack or the at least one IT device, wherein the at least one arcuate region of the busbar at least partially conforms to an external circumference of the at least one cooling pipe;
      and
   a thermal interface between the at least one cooling pipe and the at least one arcuate region, wherein the thermal interface comprises at least one thermally conductive material.
2. The busbar assembly of clause 1, wherein the metallic sheet is at least partially fashioned of copper.
3. The busbar assembly of any one of the clauses 1 to 2, wherein the at least one cooling pipe is at least partially fashioned of copper.
4. The busbar assembly of any one of the clauses 1 to 3, wherein the at least one thermally conductive material includes one or more carbon nanotubes.
5. The busbar assembly of any one of the clauses 1 to 4, wherein the busbar is roll formed for thermal contact with not less than 30 percent of the external circumference of the at least one cooling pipe.
6. The busbar assembly of any one of the clauses 1 to 5, wherein the thermal interface is configured for thermal contact with not less than 30 percent of the external circumference of the at least one cooling pipe.
7. The busbar assembly of any one of the clauses 1 to 6, wherein:
   the current load is a first current load; wherein the at least one thermally conductive material is an electrically conductive material; and wherein the at least one cooling pipe is configured to carry a second current load between the power source and the at least one IT device.
8. The busbar assembly of clause 7, wherein: the at least one cooling pipe is connected to the fluid network via at least one electrically non-conductive fitting.
9. The busbar assembly of clause 8, wherein the fluid refrigerant is an electrically non-conductive fluid.
10. A method for providing operating power, the method comprising: providing at least one information technology (IT) device disposed within a rack; providing a power source configured for supplying operating current to the at least one IT device; providing a fluid network configured for thermal management of the at least one IT device, wherein the fluid network comprises at least one cooling pipe configured for circulating a fluid refrigerant through one or more of the rack or the at least one IT device; providing at least one busbar attached to the rack, wherein the busbar is configured to carry a current load between the power source and the at least one IT device, wherein the at least one busbar comprises a metallic sheet roll formed into at least one arcuate region, and wherein the at least one arcuate region at least partially conforms to an external circumference of the at least one cooling pipe; and providing a thermal interface between the at least one arcuate region and the at least one cooling pipe, wherein the thermal interface comprises at least one thermally conductive material.
11. The method of clause 10, wherein providing at least one busbar attached to the rack includes: providing at least one busbar, wherein the at least one busbar comprises a metallic sheet at least partially fashioned of copper.
12. The method of any one of the clauses 10 to 11, wherein providing at least one busbar attached to the rack includes: providing at least one busbar configured for thermal contact with not less than 30 percent of the external circumference of the at least one cooling pipe.
13. The method of any one of the clauses 10 to 12, wherein providing a fluid network configured for thermal management of the at least one IT device includes: providing a fluid network wherein the at least one cooling pipe is at least partially fashioned of copper.
14. The method of any one of the clauses 10 to 13, wherein providing a thermal interface between the at least one arcuate region and the at least one cooling pipe, wherein the thermal interface comprises at least one thermally conductive material includes: providing a thermal interface wherein the at least one thermally conductive material includes one or more carbon nanotubes.
15. The method of any one of the clauses 10 to 14, wherein providing a thermal interface between the at least one arcuate region and the at least one cooling pipe, wherein the thermal interface comprises at least one thermally conductive material includes: providing a thermal interface configured for thermal contact with not less than 30 percent of the external circumference of the at least one cooling pipe.
16. The method of any one of the clauses 10 to 15, wherein: the current load is a first current load; wherein the at least one thermally conductive material includes at least one electrically conductive material; and wherein providing a fluid network configured for thermal management of the at least one IT device includes: connecting the at least one cooling pipe to the fluid network via at least one electrically non-conductive fitting.
17. The method of clause 16, wherein providing a fluid network configured for thermal management of the at least one IT device includes: circulating an electrically non-conductive fluid refrigerant through one or more of the rack or the at least one IT device.
18. The method of clause 17, further comprising: providing, via the at least one cooling pipe, a second current load between the power source and the at least one IT device.

It is contemplated that examples of the inventive concepts disclosed herein may have numerous advantages. For example, as noted above, the liquid-cooled roll-formed busbar may accommodate increases in current capacity associated with present and future AI/ML applications, while minimizing the need for additional busbar material and thereby controlling both overall cost and cost volatility. Further, by employing cooper cooling pipes as supplementary current carriers, additional current capacity may be achieved without enlarging or expanding the busbar proper.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various examples of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects The invention is defined by the appended claims.

## Claims

1. A busbar assembly (300), comprising:
at least one busbar (302) attached to a rack, the busbar (302) configured to carry a current load between a power source and at least one information technology, IT, device disposed within the rack, the at least one busbar (302) comprising a metallic sheet roll formed into at least one arcuate region (302a);
at least one cooling pipe (304) defining a portion of a fluid network configured for circulating a fluid refrigerant through at least one of the rack or the at least one IT device, wherein the at least one arcuate region (302a) of the busbar (302) at least partially conforms to an external circumference of the at least one cooling pipe (304);
and
a thermal interface (306) between the at least one cooling pipe (304) and the at least one arcuate region (302a), wherein the thermal interface (306) comprises at least one thermally conductive material.

2. The busbar assembly of claim 1, wherein the metallic sheet is at least partially fashioned of copper.

3. The busbar assembly of any one of claims 1 to 2, wherein the at least one cooling pipe is at least partially fashioned of copper.

4. The busbar assembly of any one of claims 1 to 3, wherein the at least one thermally conductive material includes one or more carbon nanotubes.

5. The busbar assembly of any one of claims 1 to 4, wherein the busbar is roll formed for thermal contact with not less than 30 percent of the external circumference of the at least one cooling pipe.

6. The busbar assembly of any one of claims 1 to 5, wherein the thermal interface is configured for thermal contact with not less than 30 percent of the external circumference of the at least one cooling pipe.

7. The busbar assembly of any one of claims 1 to 6, wherein:
the current load is a first current load;
wherein the at least one thermally conductive material is an electrically conductive material;
and
wherein the at least one cooling pipe is configured to carry a second current load between the power source and the at least one IT device.

8. The busbar assembly of claim 7, wherein:
the at least one cooling pipe is connected to the fluid network via at least one electrically non-conductive fitting.

9. The busbar assembly of claim 8, wherein the fluid refrigerant is an electrically non-conductive fluid.

10. A method for providing operating power, the method comprising:
providing at least one information technology, IT, device disposed within a rack;
providing a power source configured for supplying operating current to the at least one IT device;
providing a fluid network configured for thermal management of the at least one IT device, wherein the fluid network comprises at least one cooling pipe configured for circulating a fluid refrigerant through one or more of the rack or the at least one IT device;
providing at least one busbar attached to the rack, wherein the busbar is configured to carry a current load between the power source and the at least one IT device, wherein the at least one busbar comprises a metallic sheet roll formed into at least one arcuate region, and wherein the at least one arcuate region at least partially conforms to an external circumference of the at least one cooling pipe;
and
providing a thermal interface between the at least one arcuate region and the at least one cooling pipe, wherein the thermal interface comprises at least one thermally conductive material.

11. The method of claim 10, wherein providing at least one busbar attached to the rack includes:
providing at least one busbar, wherein the at least one busbar comprises a metallic sheet at least partially fashioned of copper.

12. The method of any one of claims 10 to 11, wherein providing at least one busbar attached to the rack includes:
providing at least one busbar configured for thermal contact with not less than 30 percent of the external circumference of the at least one cooling pipe.

13. The method of any one of claims 10 to 12, wherein providing a fluid network configured for thermal management of the at least one IT device includes:
providing a fluid network wherein the at least one cooling pipe is at least partially fashioned of copper.

14. The method of any one of claims 10 to 13, wherein providing a thermal interface between the at least one arcuate region and the at least one cooling pipe, wherein the thermal interface comprises at least one thermally conductive material includes:
providing a thermal interface wherein the at least one thermally conductive material includes one or more carbon nanotubes.

15. The method of any one of claims 10 to 14, wherein providing a thermal interface between the at least one arcuate region and the at least one cooling pipe, wherein the thermal interface comprises at least one thermally conductive material includes:
providing a thermal interface configured for thermal contact with not less than 30 percent of the external circumference of the at least one cooling pipe;
and optionally wherein: the current load is a first current load; wherein the at least one thermally conductive material includes at least one electrically conductive material; and wherein providing a fluid network configured for thermal management of the at least one IT device includes: connecting the at least one cooling pipe to the fluid network via at least one electrically non-conductive fitting;
and optionally wherein providing a fluid network configured for thermal management of the at least one IT device includes: circulating an electrically non-conductive fluid refrigerant through one or more of the rack or the at least one IT device;
and optionally the method further comprising providing, via the at least one cooling pipe, a second current load between the power source and the at least one IT device.
